# FASCICULE DE BREVET EUROPEEN

(11) **EP 2 784 254 B1**
(45) Date de publication et mention de la délivrance du brevet: **14.09.2016**
(21) Numéro de dépôt: 14161575.7
(22) Date de dépôt: 25.03.2014
(51) Int. Cl.: E05D 7/10, H05K 5/02, G08B 17/00

(54) **Coffret électronique muni de moyens d'anti-dégondage**
Elektronischer Verteilerkasten, der mit Sicherheitsschließmitteln ausgestattet ist
Electronic cabinet provided with a means for preventing unhinging

(30) Priorité: 26.03.2013 FR 1352717
(43) Date de publication de la demande: 01.10.2014
(73) Titulaire: Hager Security, 38920 Crolles (FR)
(72) Inventeur: Roberto, Sébastien, 38190 Bernin (FR)
(74) Mandataire: Nuss, Laurent

(56) Documents cités:
- GB-A- 2 417 483
- US-A1- 2006 026 795
- US-A1- 2011 073 157

## Description

La présente invention concerne le domaine des coffrets électroniques.

Il est connu de fixer les coffrets électroniques, en particulier de systèmes d'alarme, tels que des centrales, des transmetteurs téléphoniques, des sirènes intérieures ou extérieures, contre les murs. De tels coffrets électroniques peuvent contenir des piles électriques de façon à être autonomes. Généralement, pour changer les piles, on démonte une partie des coffrets fixée par des vis ou par des pattes d'encliquetage.

La présente invention a pour but d'améliorer la fixation des coffrets électroniques et de faciliter le changement des piles électriques.

Il est proposé un coffret électronique qui comprend un boîtier incluant un dispositif électronique et un socle pouvant être assemblés par l'intermédiaire de moyens d'articulation comprenant des pentures et des gonds pouvant être accouplés, de façon à pivoter l'un par rapport à l'autre entre une position rapprochée dans laquelle le boîtier est placé au-dessus du socle et une position d'ouverture totale.

Le boîtier présente un logement pour la réception d'un élément rapporté démontable tel qu'une pile électrique, ce logement étant, dans ladite position rapprochée, ouvert du côté du socle.

Le boîtier et le socle comprennent des moyens de butées n'autorisant le désengagement des gonds et des pentures que lorsque le boîtier est, par rapport au socle, dans au moins une position angulaire prédéterminée d'ouverture décalée angulairement par rapport à ladite position d'ouverture totale.

Le boîtier et le socle présentent, en vue de les assembler, des butées réciproques de positionnement radial pour aligner les tiges des gonds et les trous des pentures à ladite position angulaire prédéterminée d'ouverture

Ladite position angulaire prédéterminée d'ouverture peut être située entre ladite position d'ouverture totale et ladite position rapprochée et décalée angulairement par rapport à ces positions.

Les moyens d'articulations peuvent comprendre des gonds et des pentures pouvant être accouplés axialement et les moyens de butées peuvent comprendre des portions aménagées respectivement sur le boîtier et le socle, ces portions présentant des faces venant en vis-à-vis et glissant l'une par rapport à l'autre lorsque le socle et le boîtier, assemblés, sont pivotés l'un par rapport à l'autre entre d'une part ladite position angulaire prédéterminée d'ouverture et ladite position fermée et d'autre part entre ladite position angulaire prédéterminée d'ouverture et ladite position d'ouverture totale.

Lesdits moyens de butées peuvent agir par combinaison de formes.

Lesdits moyens de butées peuvent être d'une seule pièce avec d'une part le boîtier et d'autre part le socle.

Un coffret électronique selon la présente invention va maintenant être décrit à titre d'exemple non limitatif et illustré par le dessin sur lequel :
- la figure 1 représente une vue de dessous d'un coffret comprenant un boîtier et un socle en position rapprochée ;
- la figure 2 représente une vue de dessous du coffret de la figure 1, le boîtier et le socle étant dans une position d'ouverture partielle ;
- la figure 3 représente une vue de la face arrière du boîtier et de la face avant du socle en perspective ;
- la figure 4 représente une vue agrandie d'un moyen d'articulation entre le boîtier et le socle, selon la disposition de la figure 3 ;
- la figure 5 représente une coupe selon V-V de la figure 4, le boîtier et le socle étant dans une position angulaire intermédiaire de dégondage;
- la figure 6 représente une coupe selon VI-VI de la figure 4, le boîtier et le socle étant dans une position angulaire d'ouverture partielle différente de celle de la figure 5 ; et

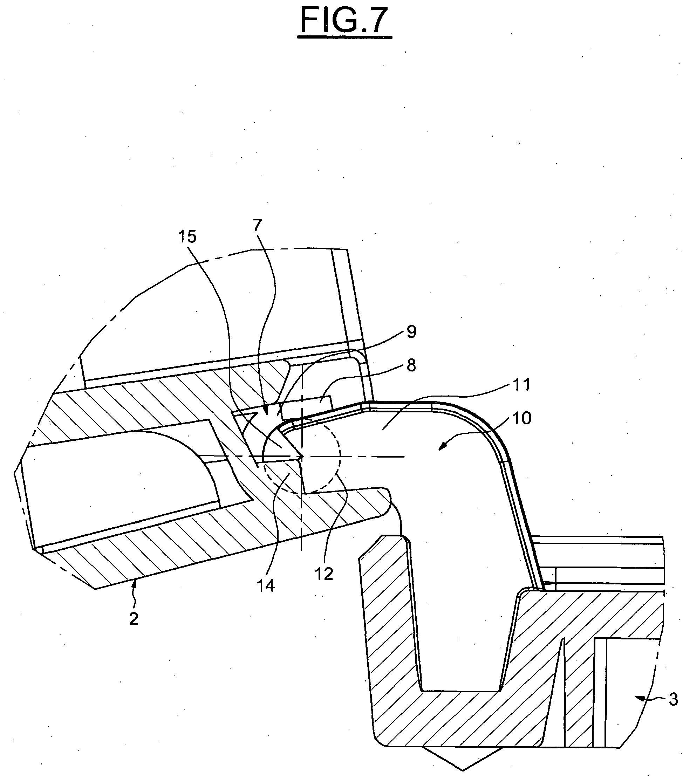

- la figure 7 représente une coupe selon VII-VII de la figure 4, le boîtier et le socle étant dans une autre position angulaire d'ouverture partielle différente de celle de la figure 5.

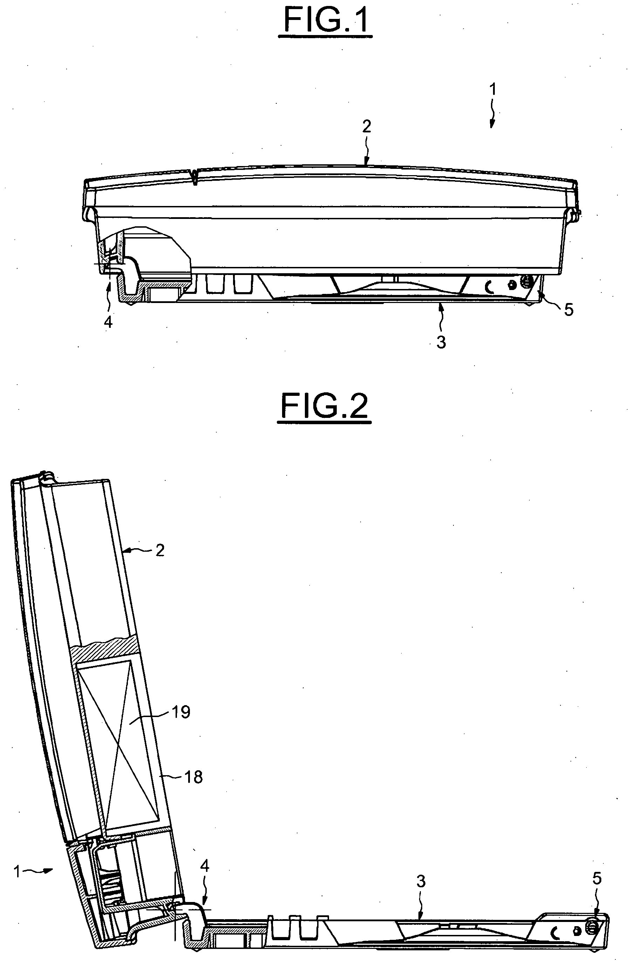

Comme illustré en particulier sur les figures 1 à 3, un coffret électronique 1, qui va être considéré comme étant dans une position verticale d'installation, comprend un boîtier 2 substantiellement parallélépipédique, qui contient un dispositif électronique (non représenté), et un socle 3 se présentant substantiellement sous la forme d'une plaque.

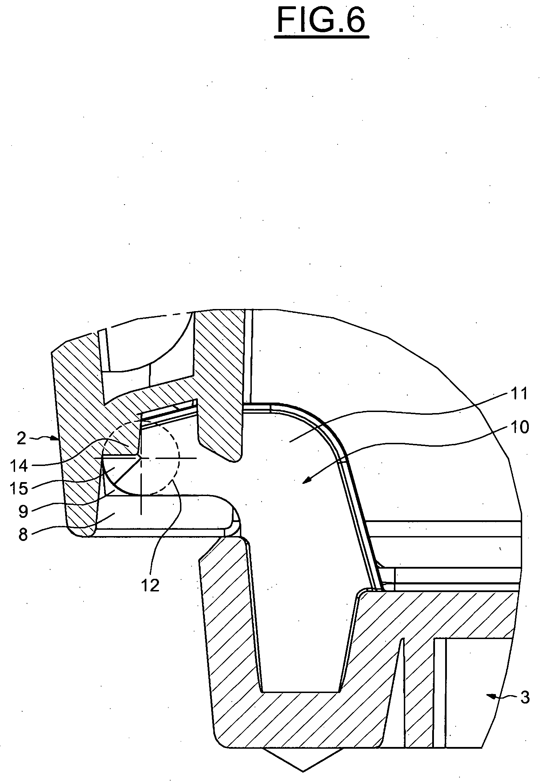

Le boîtier 2 et le socle 3 sont reliés, d'un côté vertical, par des moyens d'articulation 4, permettant de faire pivoter librement le boîtier 2 par rapport au socle 3 entre une position rapprochée dans laquelle le boîtier 2 est à plat au-dessus et contre le socle 3 (figure 1) et une position écartée d'ouverture totale (figure 6), limitée par des moyens de butées, non représentés. Par exemple, l'angle d'ouverture total peut être d'environ 180°.

Le boîtier 2 et le socle 3 comprennent entre eux, de l'autre côté vertical, des moyens de verrouillage 5, tels qu'un verrou ou une gâche, permettant de maintenir le boîtier 2 dans ladite position rapprochée.

Le socle 3 présente des trous de fixation 6 pour le passage de vis de fixation du socle 3 par exemple contre un mur.

Les moyens d'articulation 4 sont formés de la manière suivante. Le boîtier 2 comprend des pentures 7 comprenant des portions 8, en saillie horizontalement, dans lesquelles sont aménagés des trous verticaux coaxiaux 9 et le socle 3 comprend des gonds 10 comprenant des pattes 11, en saillie horizontalement, sur lesquelles sont prévues des tiges verticales coaxiales 12 s'étendant vers le haut et pouvant être engagées dans les trous 8 des pentures 7. Dans l'exemple représenté, trois pentures et trois gonds associés, décalés verticalement, sont prévus.

Lorsque le boîtier 2 et le socle 3 sont assemblés, les tiges verticales 12 des gonds 10 sont engagées dans les trous verticaux 8 des pentures 7, les portions en saillie 8 s'étendant au-dessus des pattes en saillie 11. Les portions en saillie 8 et les pattes en saillie 11 présentent des faces adjacentes 8a et 11a s'étendant substantiellement radialement aux trous verticaux 9 et aux axes verticaux 12 et en appui les unes sur les autres.

Le boîtier 2 présente des espaces de dégagement 13 situés au-dessous des portions en saillie 8, dans lesquelles les pattes en saillie 11 du socle 3 sont engagées et qui se prolongent vers le bas au-delà de ces pattes en saillie 11.

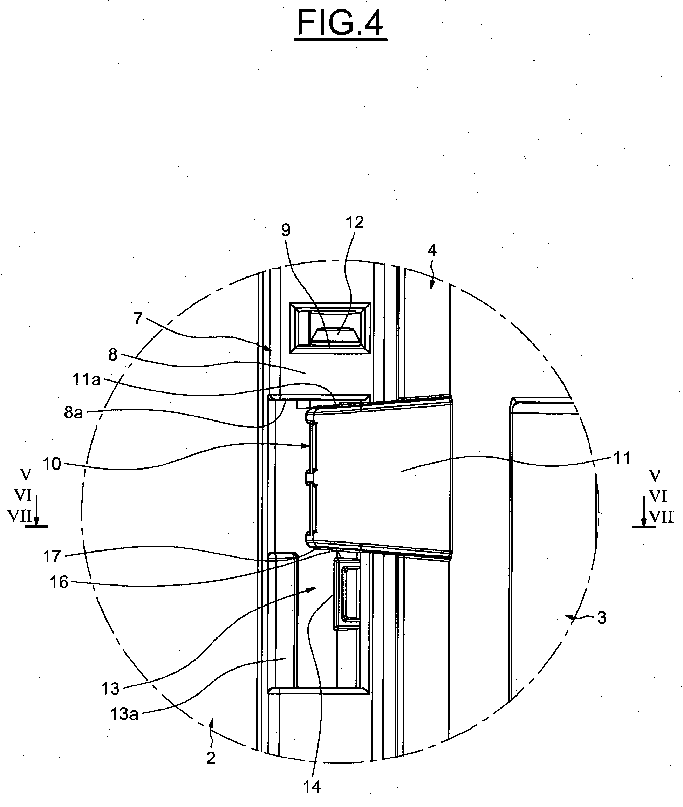

Dans au moins l'un des espaces en creux 13 et au-dessous et à distance de la portion en saillie 8 correspondante, par exemple l'espace en creux du moyen d'articulation intermédiaire (figure 4), le boîtier 2 présente une nervure verticale en saillie 14, en forme de coin en V, qui est située juste au-dessous de la patte en saillie 11 correspondante du socle 2 lorsque le boîtier 2 et le socle 3 sont assemblés.

La patte en saillie 11 correspondante du socle 3 présente, dans son flanc d'extrémité, une rainure verticale en creux 15, également en forme de coin en V et dont la forme correspond à celle de la nervure 14.

La nervure verticale en saillie 14 et la rainure en creux 15 sont placées de telle sorte que, lorsque le boîtier 2 et le socle 3, assemblés, sont dans une position angulaire intermédiaire d'ouverture, par exemple l'un par rapport à l'autre à environ 120° et selon une certaine tolérance angulaire, la nervure verticale en saillie 14 et la rainure en creux 15 sont alignées verticalement (figure 4).

Dans cette position d'alignement, le boîtier 2 et le socle 3 peuvent alors être déplacés verticalement l'un par rapport à l'autre, axialement aux trous verticaux 9 et aux axes verticaux 12, la nervure verticale en saillie 14 et la rainure en creux 15 s'engageant verticalement l'une dans l'autre en empêchant le boîtier 2 de pivoter par rapport au socle 3. Lorsque les tiges verticales 12 sont extraites des trous verticaux 9, en position dégondée, le boîtier 2 et le socle 3 peuvent être complètement séparés, les pattes en saillie 11 du socle 3 s'extrayant des espaces de dégagement 13 du boîtier 2.

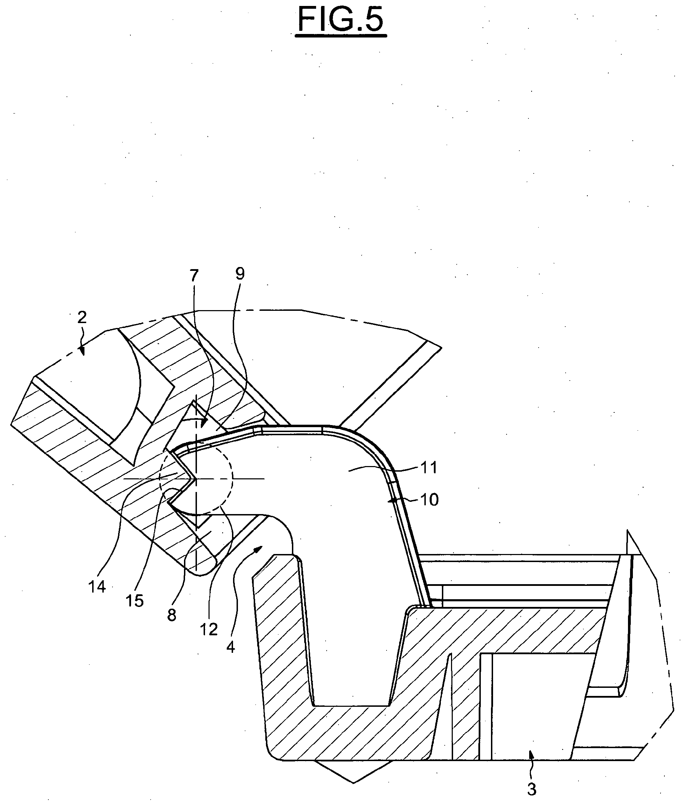

Lorsque le boîtier 2 et le socle 3, assemblés, sont pivotés d'une part entre ladite position angulaire intermédiaire d'ouverture et ladite position rapprochée (figure 5) ou entre ladite position angulaire intermédiaire d'ouverture et ladite position d'ouverture totale (figure 6), la nervure verticale 14 et la rainure verticale 15 ne sont plus alignées. La face supérieure d'extrémité 16 de la nervure verticale 14 du boîtier 2 et la face inférieure 17 de la patte en saillie 11 du socle 3 correspondante glissent radialement à faible distance l'une par rapport à l'autre et forment des butées axiales réciproques d'anti-dégondage qui s'opposent au déplacement du boîtier 2 et du socle 3 vers la position dégondée précitée.

Ainsi, la position angulaire intermédiaire d'ouverture du boîtier 2 par rapport au socle 3 constitue une position angulaire spécifique de dégondage possible, tandis que toutes les autres positions du boîtier 2 par rapport au socle 3 constituent des positions d'anti-dégondage

Le boîtier 2 étant séparé du socle 3, pour assembler ces derniers il convient d'engager les extrémités des pattes 11 du socle 3 dans les parties inférieures des espaces de dégagement 13 du boîtier 2, qui présentent des parois 13a constituant des butées de positionnement radial contre lesquelles les extrémités des pattes 11 viennent en contact de façon à aligner les tiges 12 des gonds 10 et les trous 9 des pentures 7, et concomitamment d'engager la nervure verticale 14 dans la rainure 15, le boîtier 2 et le socle 3 étant placés dans ladite position angulaire intermédiaire d'ouverture, puis de déplacer le boîtier 2 par rapport au socle 3 de façon à engager les tiges verticales 12 des gonds 10 dans les trous verticaux 9 des pentures 8 jusqu'à ladite position assemblée.

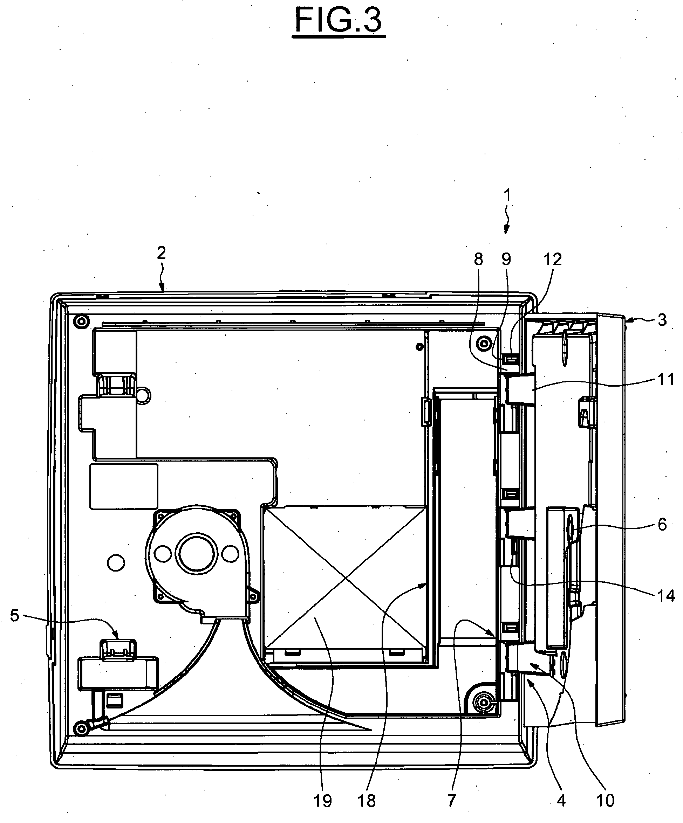

Comme illustré sur les figures 2 et 3, le boîtier 2 présente, dans sa face arrière, un logement arrière en creux 18 qui est ouvert du côté de la face avant du socle 3 lorsque le boîtier 2 et le socle 3 sont dans ladite position rapprochée. Ce logement en creux 18 est destiné à recevoir une pile électrique 19 d'alimentation électrique du dispositif électronique inclus dans le boîtier 2.

Le socle 3 étant fixé contre un mur, en hauteur, et le boîtier 2 étant assemblé au socle 3 comme décrit précédemment, si un utilisateur, par exemple grimpé sur une échelle, souhaite mettre en place une pile électrique 19 dans le logement 18 du boîtier 2 ou l'en extraire, il peut le faire sans risque de provoquer une séparation du boîtier 2 par rapport au socle 3 et donc sans risque que le boîtier 2 ne chute et se détériore.

En effet, après avoir actionné les moyens de verrouillage 5, l'utilisateur fait pivoter le boîtier 2 par rapport au socle 3 jusqu'à ladite position d'ouverture totale, ou toute autre position dans laquelle le dégondage est impossible. Cette impossibilité de dégondage autorise l'utilisateur à exercer, sans risques, notamment des forces vers le haut sur le boîtier 2 lors de la mise en place ou l'extraction d'une pile électrique 19.

En outre, l'impossibilité de dégondage sur toute la course angulaire du boîtier 2 par rapport au socle 3, hormis lorsqu'ils sont à ladite position angulaire intermédiaire d'ouverture permettant l'assemblage du boîtier 2 sur le socle 3 et leur séparation, limite considérablement les risques de séparation et de chute du boîtier 2 si l'utilisateur heurte malencontreusement ce dernier.

Selon une variante de réalisation, le boîtier 2 pourrait comprendre, à la place de la nervure en saillie 14, deux plots de butée en saillie décalés angulairement par rapport à une patte en saillie 11 du socle 3, placés dans l'espace de dégagement 13 correspondant et au-dessous de cette patte 11 lorsque le boîtier 2 et le socle 3 sont assemblés.

Dans ladite position intermédiaire d'ouverture, cette patte 11 pourrait passer entre ces plots en saillie lors du déplacement du boîtier 2 par rapport au socle 3 lors de l'assemblage du boîtier 2 et du socle 3 ou lors de leur séparation comme décrit précédemment, tandis que, le boîtier 2 et le socle 3 étant assemblés, cette patte 11 glisserait, à faible distance, soit au-dessus de l'un de ces plots soit au-dessus de l'autre dans toutes les autres positions angulaires du boîtier 2 par rapport au socle 3 pour empêcher le dégondage.

Dans une autre variante de réalisation, lesdits plots formant des butées pourraient coopérer avec des pattes 11 différentes du socle 2.

Il résulte de ce qui précède que les moyens de butées d'anti-dégondage proposés, qui agissent par conjugaison de formes, peuvent être obtenus d'une seule pièce d'une part avec le boîtier 2 et d'autre part avec le socle 3, qui peuvent être en une matière plastique injectée.

La présente invention ne se limite pas à l'exemple ci-dessus décrit. Bien des variantes de réalisation sont possibles sans sortir du cadre de l'invention.

## Revendications

1. Coffret électronique comprenant un boîtier (2) incluant un dispositif électronique et un socle (3) pouvant être assemblés par l'intermédiaire de moyens d'articulation (4) comprenant des pentures (7) et des gonds (10) pouvant être accouplés, de façon à pivoter l'un par rapport à l'autre entre une position rapprochée dans laquelle le boîtier est placé au-dessus du socle et une position d'ouverture totale, le boîtier (2) présentant un logement (18) pour la réception d'un élément rapporté démontable (19) tel qu'une pile électrique, ce logement étant, dans ladite position rapprochée, ouvert du côté du socle, dans lequel le boîtier (2) et le socle (3) comprennent des moyens de butées (11, 14) n'autorisant le désengagement des gonds et des pentures que lorsque le boîtier (2) est, par rapport au socle (3), dans au moins une position angulaire prédéterminée d'ouverture décalée angulairement par rapport à ladite position d'ouverture totale ; et dans lequel le boîtier et le socle présentent, en vue de les assembler, des butées réciproques de positionnement radial (11, 13 a) pour aligner les tiges des gonds et les trous des pentures à ladite position angulaire prédéterminée d'ouverture.

2. Coffret selon la revendication 1, dans lequel ladite position angulaire prédéterminée d'ouverture est située entre ladite position d'ouverture totale et ladite position rapprochée et décalée angulairement par rapport à ces positions.

3. Coffret selon l'une des revendications 1 et 2, dans lequel les moyens d'articulations comprennent des gonds et des pentures pouvant être accouplés axialement et dans lequel les moyens de butées comprennent des portions aménagées (11, 14) respectivement sur le boîtier et le socle, ces portions présentant des faces venant en vis-à-vis et glissant l'une par rapport à l'autre lorsque le socle et le boîtier, assemblés, sont pivotés l'un par rapport à l'autre entre d'une part ladite position angulaire prédéterminée d'ouverture et ladite position fermée et d'autre part entre ladite position angulaire prédéterminée d'ouverture et ladite position d'ouverture totale.

4. Coffret selon l'une quelconque des revendications précédentes, dans lequel lesdits moyens de butées agissent par combinaison de formes.

5. Coffret selon l'une quelconque des revendications précédentes, dans lequel lesdits moyens de butées sont d'une seule pièce avec d'une part le boîtier et d'autre part le socle.

## Patentansprüche

1. Elektronischer Verteilerkasten, umfassend ein Gehäuse (2) das eine elektronische Vorrichtung und einen Sockel (3) enthält, der mit Hilfe von Gelenkmitteln (4) zusammengesetzt werden kann, die Bänder (7) und Kloben (10) umfassen, die derart gekoppelt sein können, dass sie relativ zueinander zwischen einer herangezogenen Position, in der das Gehäuse oberhalb des Sockels angeordnet ist, und einer vollständig geöffneten Position schwenkbar sind, wobei das Gehäuse (2) einen Sitz (18) für die Aufnahme eines abnehmbaren Anbauelements (19), wie beispielsweise einer elektrischen Batterie, aufweist, wobei dieser Sitz in der herangezogenen Position sockelseitig offen ist, wobei das Gehäuse (2) und der Sockel (3) Anschlagseinrichtungen (11, 14) umfassen, die das Auseinanderfügen der Kloben und der Bänder nur zulassen, wenn sich das Gehäuse (2) in Bezug auf den Sockel (3) in mindestens einer vorbestimmten geöffneten Winkelposition, die in Bezug auf die vollständig geöffnete Winkelposition winkelversetzt ist, befindet; und wobei das Gehäuse und der Sockel, um sie zusammenzufügen, gegenseitige Anschläge zur radialen Positionierung (11, 13a) aufweisen, um die Klobenstangen und die Öffnungen der Bänder an der vorbestimmten geöffneten Winkelposition auszurichten.

2. Verteilerkasten nach Anspruch 1,
wobei die vorbestimmte geöffnete Winkelposition zwischen der vollständig geöffneten Position und der herangezogenen Position liegt und in Bezug auf diese Positionen winkelversetzt ist.

3. Verteilerkasten nach einem der Ansprüche 1 und 2,
wobei die Scharniereinrichtungen Kloben und Bänder umfassen, die axial gekoppelt sein können und wobei die Anschlagseinrichtungen Abschnitte (11, 14) umfassen, jeweils auf dem Gehäuse und dem Sockel eingerichtet sind, wobei diese Abschnitte Seiten aufweisen, die einander gegenüber liegen und relativ zueinander gleiten, wenn der Sockel und das Gehäuse relativ zueinander einerseits zwischen der vorbestimmten geöffneten Winkelposition und der geschlossenen Position und andererseits zwischen der vorbestimmten geöffneten Winkelposition und der vollständigen Öffnungsposition geschwenkt werden und zusammengefügt sind.

4. Verteilerkasten nach einem der vorhergehenden Ansprüche,
wobei die Anschlagseinrichtungen durch Kombination von Formen wirken.

5. Verteilerkasten nach einem der vorhergehenden Ansprüche,
wobei die Anschlagseinrichtungen einerseits mit dem Gehäuse und anderseits mit dem Sockel einstückig sind.

## Claims

1. Electronic cabinet comprising a casing (2) including an electronic device and a base (3) which can be assembled by articulation means (4) comprising hinges (7) and hinge pins (10) which can be coupled together so that they pivot relative to one another between an approached position in which the casing is placed above the base and a fully opened position, the casing (2) having an housing (18) for receiving a removable inserted element (19) such as an electric battery, said housing being, in this approached position, open on the base side, wherein the casing (2) and the base (3) comprise stopping means (11, 14) which only allow the disengagement of the hinge pins and the hinges when the casing (2), relative to the base (3), is in at least one predetermined opened angular position offset angularly relative to said fully opened position, and wherein the casing and the base have, for the purpose of assembly, reciprocal stops for radial positioning (11, 13a) to align the rods of the hinge pins and the holes of the hinges in said predetermined angular opening position.

2. Cabinet according to claim 1, wherein said predetermined opened angular position is located between said fully opened position and said approached position which is offset angularly relative to these positions.

3. Cabinet according to any one of claims 1 and 2, wherein the articulation means comprise hinge pins and hinges which can be coupled together axially and wherein the stop means comprise parts (11, 14) adjusted respectively on the casing and the base, said parts having faces which are opposite one another and slide relative to one another when the base and the casing, once assembled, are pivoted relative to one another between on the one hand said predetermined opened angular position and said approached position and on the other hand between said predetermined opened angular position and said fully opened position.

4. Cabinet according to any one of the preceding claims, wherein said stop means act by means of a combination of forms.

5. Cabinet according to any one of the preceding claims, wherein said stop means are made in one piece with the casing on the one hand and the base on the other hand.
